# EUROPEAN PATENT APPLICATION

(11) **EP 4 718 961 A1**
(43) Date of publication of application: **01.04.2026**
(21) Application number: 25191905.6
(22) Date of filing: 25.07.2025
(51) Int. Cl.: H05K 7/20

(54) **LIQUID IMMERSION COOLING SYSTEMS**

(30) Priority: 25.09.2024 WO PCT/CN2024/120940; 14.11.2024 US 202418948081
(71) Applicant: Intel Corporation, Santa Clara, CA 95054 (US)
(72) Inventor: ZHANG, Guangying, Shanghai, 210043 (CN); WANG, Chuanlou, Shanghai, 200241 (CN); FAN, Yuehong, Shanghai, 200241 (CN); ZHOU, Shaorong, Shanghai, 200241 (CN); YAO, Yang, Shanghai, 200241 (CN); BU, Yingqiong, Shanghai, 200241 (CN); QUE, Xiang, Suzhou, 215124 (CN); YING, Guoliang, Shanghai, 200241 (CN)
(74) Representative: Maiwald GmbH

(57) **Abstract**

Immersion cooling systems are disclosed. An example immersion cooling system includes an immersion tank including a cooling fluid and a reservoir to contain a recirculated portion of the cooling fluid. The reservoir is separated from the immersion tank by a height to generate a liquid surface height variance between the cooling fluid in the immersion tank and the cooling fluid in the reservoir. A supply conduit is to fluidly couple the immersion tank and the reservoir. The cooling fluid to be provided from the reservoir to the immersion tank via gravity.

## Description

### RELATED APPLICATION

This patent is a continuation of International Patent Application Number PCT/CN2024/120940, which was filed on September 25, 2024. Priority to International Patent Application PCT/CN2024/120940 is hereby claimed. International Patent Application PCT/CN2024/120940 is hereby incorporated by reference in its entirety.

### BACKGROUND

Liquid cooling has been steadily increasing over use of air cooling in the context of high-performance computing (HPC) because liquid cooling can offer higher component density, waste heat recovery capabilities, and/or lower operating costs. One form of liquid cooling, immersion cooling, involves immersion of computing components in a coolant or dielectric liquid.

### BRIEF DESCRIPTION OF THE DRAWINGS

FIG. 1 is a schematic illustration of an example cooling infrastructure having an immersion cooling system in accordance with the teachings of this disclosure.
FIG. 2 is an enlarged portion of the example immersion cooling system of FIG. 1.
FIG. 3A is a side view of an example immersion tank of the example immersion cooling system of FIG. 2.
FIG. 3B is a side view of an example electronic component of the example immersion tank of FIG. 3A.
FIG. 3C is a perspective view of the example electronic component of FIG. 3B.
FIG. 3D is a perspective, cross-sectional view of the example electronic component of FIG. 3C.
FIG. 4 is a schematic illustration of another example cooling infrastructure having another example immersion cooling system disclosed herein.
FIG. 5 illustrates one or more example environments in which teachings of this disclosure may be implemented.
FIG. 6 illustrates at least one example of a data center for executing workloads with disaggregated resources.
FIG. 7 illustrates at least one example of a pod that may be included in the data center of FIG. 6.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

The power consumption of various types of processor units (such as XPUs (e.g., central processing units (CPUs), graphics processing units (GPUs)), add-in cards, and memories are increasing generation-over-generation. As the performance of semiconductor chips (e.g., a computing/networking systems that the chips are integrated into) continues to increase, however, so does the associated power consumption. In some instances, the performance of many semiconductor chips and computing/networking system products has crossed a threshold at which traditional air-cooling is unable to keep the chips/equipment sufficiently cool. Liquid immersion cooling is becoming an attractive option for the cooling of high-performance computing systems, such as data center servers and/or computing/network system products, due to its high heat capture rate, and enablement of low power usage effectiveness (PUE), high component reliability in corrosive atmospheric conditions, and/or modular and scalable designs. The emergence of edge computing and 5G cellular network technologies is further accelerating the adoption of liquid immersion cooling.

The use of liquids to cool electronic components is being explored for its benefits over more traditional air cooling systems, as there are increasing needs to address thermal management risks resulting from increased thermal design power in high performance systems (e.g., CPU and/or GPU servers in data centers, accelerators, artificial intelligence computing, machine learning computing, cloud computing, edge computing, and the like). More particularly, relative to air, liquid has inherent advantages of higher specific heat (when no boiling is involved) and higher latent heat of vaporization (when boiling is involved). In some instances, liquid can be used to indirectly cool electronic components by cooling a cold plate that is thermally coupled to the electronic component(s). An alternative approach is to directly immerse electronic components in the cooling liquid. In direct immersion cooling, the liquid can be in direct contact with the electronic components to directly draw away heat from the electronic components. To enable the cooling liquid to be in direct contact with electronic components, the cooling liquid (e.g., a single-phase liquid) is electrically insulative (e.g., a dielectric liquid). As used herein, single-phase cooling (e.g., single-phase immersion cooling) means the cooling fluid (sometimes also referred to herein as cooling liquid or coolant) used to cool electronic components draws heat away from heat sources (e.g., electronic components) without changing phase (e.g., without boiling and becoming vapor). Such cooling fluids are referred to herein as single-phase cooling fluids, liquids, cooling fluid, or coolants. A single phase immersion cooling can utilize an open bath immersion tank or a closed bath immersion tank.

Single-phase immersion tanks have flowrate limitations. For example, a flowrate of a single phase coolant through a heat exchanger of an electronic component (e.g., an XPU heatsink) is provided by a fluid pump. With a traditional tank, a thermal performance or cooling efficiency improvement is minimal if only increasing pump power to increase a fluid flowrate of the single phase solution in an immersion cooling system. That is, increasing fluid flow rate at an inlet panel of a chassis (with higher pump power) has minimum thermal benefit(s). As a result, the fluid flowrate of the coolant through a heat exchanger (e.g., an XPU heatsink) increases slightly even when increasing chassis inlet flow rate significantly. For example, for a typical coolant in a single phase immersion cooling system, fluid flow rate through a heat exchanger increases approximately 1.3 times when the chassis inlet flow rate is increased by approximately 7.5 times, and most of the increased flow rate (from the chassis inlet) bypasses towards a low flow impedance area in a chassis, which in essence, wastes the benefits of the increased flowrate.

Example systems, apparatus, and associated methods disclosed herein improve cooling capacity of cooling systems and/or associated cooling processes. Examples disclosed herein overcome tank height limitations to achieve higher potential energy, thereby providing higher pressure head to a heatsink (e.g., a XPU heatsink) to increase flowrate through heatsink area. To improve cooling capacity, example systems, apparatus and associated methods disclosed herein increase a flowrate of a coolant through a heat exchanger (e.g., XPU heat sink) to significantly enhance single-phase immersion cooling capability (e.g., between 900 W and 1000 W). To increase a flowrate, example systems, apparatus and methods disclosed herein generate a liquid surface height variance of coolant within an immersion tank and a reservoir to increase a pressure head of the coolant. Specifically, the reservoir is positioned above a height of the immersion tank. Thus, a distance between the immersion tank and the reservoir is greater than a height of the immersion tank. In this manner, example systems disclosed herein employ a waterfall system, which distributes coolant into one or more immersion tanks from a reservoir through waterfall pipelines. For example, systems, apparatus, and associated methods disclosed herein optimize working fluid recirculation and employ a waterfall system to gain higher gravitational potential energy in the working fluid and, thereby increase a flow rate of the working fluid (e.g., a coolant or liquid) flowing from the reservoir to the immersion tank. The additional head pressure and/or liquid surface height variance of the coolant significantly increases a flowrate of the working fluid through a heat sink of associated with one or more integrated circuit components (e.g., an XPU) immersed in an immersion tank or chamber, resulting in removing a greater amount of heat across the heat sink. With the greater head pressure, a higher flowrate can be achieved. With the increased pressure head, example cooling systems disclosed herein can achieve higher flowrates to improve cooling capability for single phase immersion cooling. Thus, liquid surface height variances is not limited to a height of an immersion tank. Instead, liquid surface height variances can be greater than a height of an immersion tank to increase a pressure head and improve flowrates through gravity driven flow, thereby improving cooling capacity of a cooling system (e.g., providing cooling capacity of between approximately 900 and 1110 Watts (W)). As used herein, "cooling capacity" measures an ability of a cooling system to remove heat.

As a result, examples disclosed herein enhance cooling capability since higher potential energy will convert to larger kinetic energy with higher fluid flow speed across heatsink. Since forced convection is dominated with higher fluid flow speed, increased convective heat transfer coefficients (HTC) are achieved. Specifically, example disclosed herein pump a coolant into a reservoir directly to achieve high potential energy in the coolant, which then flows through the heat exchanger (e.g., a CPU/GPU heatsink area) very efficiently with a higher flow rate and much higher forced convective HTC, thereby significantly improve cooling capability accordingly.

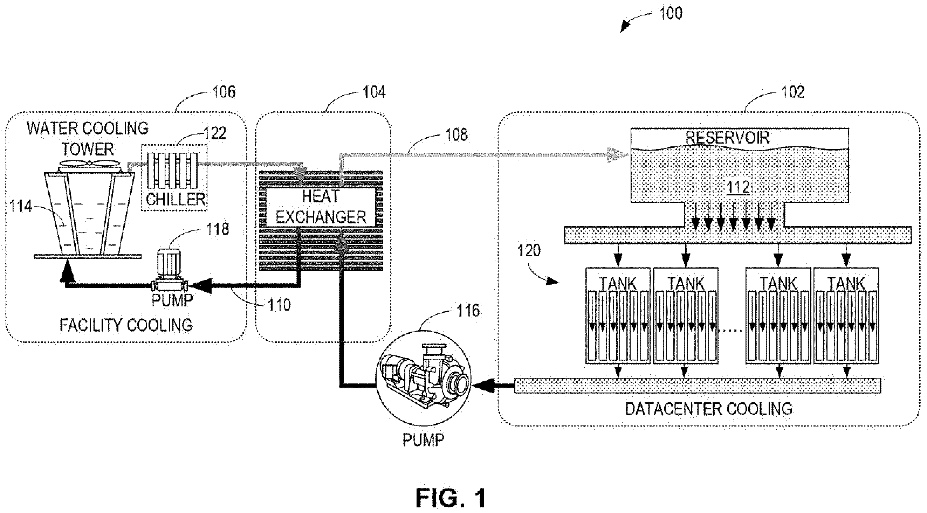

FIG. 1 is a schematic illustration of an example computing environment 100 having an example immersion cooling system 102 in accordance with teachings of this disclosure. The computing environment 100 can be, for example, a data center or cloud service nerve center. The computing environment 100 includes the immersion cooling system 102, a first heat exchanger or chiller 104 and a second heat exchanger or cooling tower 106. A first loop system 108 (e.g., a first plurality of pipes, conduits, hoses, flexible pipes, rigid pipes, valves, etc.) fluidly couples the immersion cooling system 102 and the chiller 104. A second loop system 110 (e.g., a first plurality of pipes, conduits, hoses, flexible pipes, rigid pipes, valves, etc.) fluidly couples the chiller 104 and the cooling tower 106. The first loop system 108 of the illustrated example provides or recirculates a first working fluid 112 (e.g., a coolant, a cooling fluid, etc.) and the second loop system 110 of the illustrated example provides or recirculates a second working fluid 114 (e.g., a coolant, water, a cooling fluid, etc.). The first working fluid 112 can be a dielectric material, a hydrocarbon material(s), synthetic oils, hydrocarbon-based dielectric material(s) and/or any other material(s). The second working fluid 114 can be water and/or any other cooling liquid (single-phase liquid, a two-phase liquid, etc.).

The first loop system 108 and the second loop system 110 of the illustrated example are closed looped systems. Specifically, the first loop system 108 is independent of the second loop system 110. Thus, the first loop system 108 is fluidly isolated from the second loop system 110 such that the first working fluid 112 does not mix with the second working fluid 114. A first pump 116 circulates the first working fluid 112 through the immersion cooling system 102 and the chiller 104 via the first loop system 108. A second pump 118 circulates the second working fluid 114 through the cooling tower 106 and the chiller 104 via the second loop system 110.

During operation, the immersion cooling system 102 cools electronic components 120 (e.g., servers and/or other IT equipment) of the computing environment 100. The immersion cooling system 102 employs the first working fluid 112 to remove heat from the electronic components 120. For example, as the electronic components 120 generate heat, the first working fluid 112 of the immersion cooling system 102 removes heat generated by the electronic components 120 via the first loop system 108. The warmed first working fluid 112 emitted from the immersion cooling system 102 is drawn away from the electronic components 120 and directed to the chiller 104 via the first pump 116 and the first loop system 108. The chiller 104 receives the second working fluid 114 (e.g., water) from the cooling tower 106 via the second pump 118 and the second loop system 110. The chiller 104 transfers heat from the warmed first working fluid 112 of the immersion cooling system 102 to the cooler second working fluid 114 received from the cooling tower 106. The removal of heat from the first working fluid 112 received by the chiller 104 via the first loop system 108 causes the first working fluid 112 to cool, which is routed or recirculated to the immersion cooling system 102 for cooling the electronic components 120. The warmed second working fluid 114 of the second loop system 110 exiting the chiller 104 routes or recirculates to a third heat exchanger or second chiller 122 associated with the cooling tower 106. The second chiller 122 removes heat from the second working fluid 114, which is recirculated to the cooling tower 106 for cooling the first working fluid 112. In some examples, the second chiller 122 can be omitted.

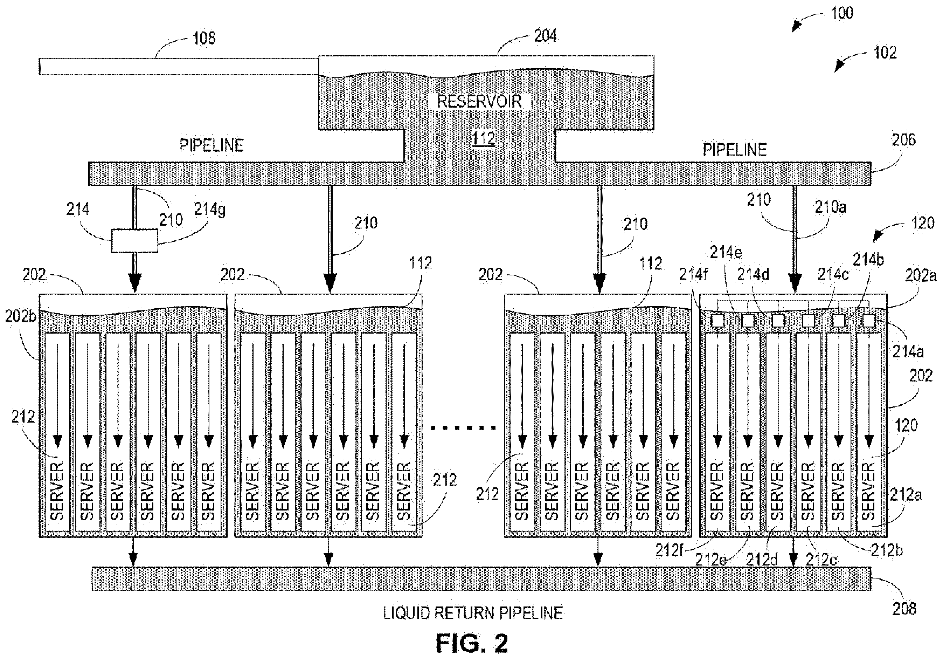

FIG. 2 is a schematic illustration of the example immersion cooling system 102 of FIG. 1. The immersion cooling system 102 of the illustrated example includes a plurality of immersion tanks 202 (e.g., one or more chambers), a reservoir 204 (e.g., or chamber), a supply manifold 206, a return manifold 208, and a plurality of waterfall conduits 210. Each of the immersion tanks 202 is fluidly coupled to a respective one of the waterfall conduits 210. The immersion tanks 202 and the reservoir 204 contain (e.g., are at least partially filled with) the first working fluid 112. Additionally, the immersion tanks 202 include the electronic components 120. The electronic components 120 are submerged in the first working fluid 112 of the immersion tanks 202. In the illustrated example, the electronic components include a plurality of servers 212. In the illustrated example, each immersion tank 202 includes six servers 212. For example, a first immersion tank 202a includes a first server 212a, a second server 212b, a third server 212c, a fourth server 212d, a fifth server 212e and a sixth server 212f. However, in other examples, each immersion tank 202 can include only one server 212, two servers 212, three servers 212 or any other number of servers 212. In some examples, one or more of the servers 212 can be the same or different.

The reservoir 204 of the illustrated example stores or contains a portion (e.g., a volume) of the first cooling fluid 112 (e.g., a recirculated portion or volume of the cooling fluid 114). The reservoir 204 and/or the supply manifold 206 is spaced from the immersion tanks 202. Specifically, the reservoir 204 and/or the supply manifold 206 are positioned above the immersion tanks 202. For example, the reservoir 204 is positioned at a first elevation and the immersion tanks 202 are positioned at a second elevation. The first elevation is greater than the second elevation. In some examples, the reservoir 204 can be located on a second floor, a third floor, or a roof of a datacenter or building and the immersion tanks 202 can be located on a first floor or in a basement of a datacenter or building. In other words, the reservoir 204 is positioned above the immersion tanks 202 to establish a liquid surface height variance (ΔH_{gravity}) between the first working fluid 112 in the reservoir 204 and the first working fluid 112 in the immersion tanks 202 to enable the first working fluid 112 to flow between the reservoir 204 and the immersion tanks 202 via gravity. Establishing a liquid surface height variance enables distribution and/or flow of the first working fluid 112 between the reservoir 204 and the immersion tanks 202 (e.g., the first immersion tank 202a) without use of a pump, thereby improving an efficiency of the immersion cooling system 102. Additionally, establishing a liquid surface height variance improves and/or increases a pressure head and/or a change in pressure between the first working fluid 112 in the reservoir 204 and the first working fluid 112 in the immersion tank 202 resulting in an increased flow rate of the first working fluid 112 through heat exchangers of the electronic components 120 and/or servers 212, thereby increasing cooling capacity of the immersion cooling system 102.

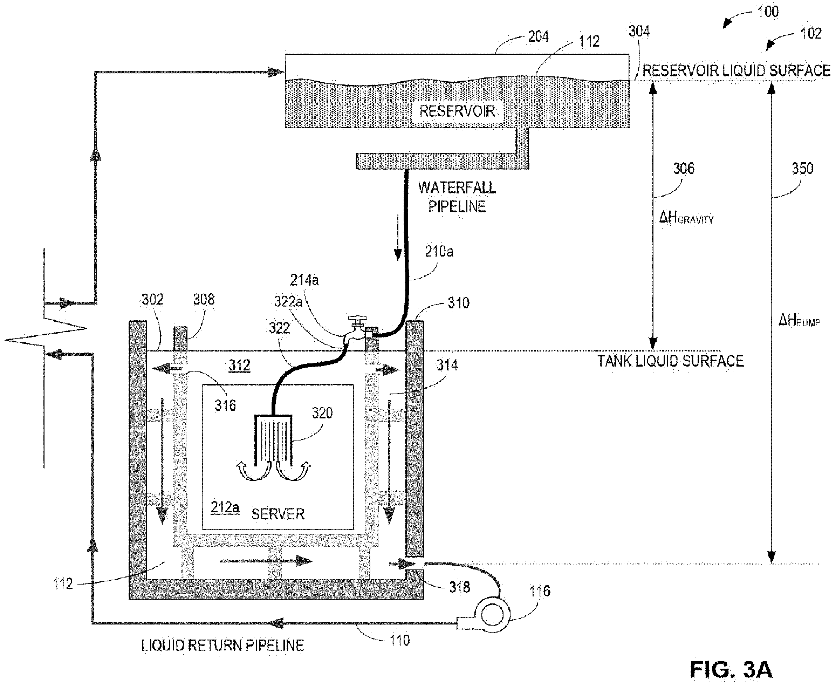

To provide the first working fluid 112 from the reservoir 204 to the immersion tanks 202, the immersion cooling system 102 includes the waterfall conduits 210. The waterfall conduits 210 move the first working fluid 112 between the reservoir 204 and the immersion tanks 202 via gravity. Thus, the waterfall conduits 210 of the illustrated example extend between the reservoir 204 and the immersion tanks 202. Specifically, the waterfall conduits 210 of the illustrated example fluidly couple the supply manifold 206 and the servers 212 positioned in the immersion tanks 202. However, in some examples, the supply manifold 206 is not needed and the waterfall conduits 210 can be coupled directly to the reservoir 204. In the illustrated example, the waterfall conduits 210 extending between the reservoir 204 and the one or more immersion tanks 202 are substantially vertical (e.g., vertical or within 10 percent of perfectly vertical) to enable the first working fluid 112 to flow from the reservoir 204 to the one or more immersion tanks 202 via gravity. In some examples, the waterfall conduits 210 can be positioned at an angle relative to vertical (e.g., between approximately 10 degrees and 60 degrees relative to vertical). As described in greater detail in connection with FIGS. 3A-3D, each of the waterfall conduits 210 are fluidly coupled to a heat exchanger (e.g., a heat sink, a cold plate, etc.) of the servers.

A flowrate (e.g., a maximum flow rate) of the first working fluid 112 from the reservoir 204 to the servers 212 is based on a liquid surface height variance (ΔH_{gravity}) provided by a distance (e.g., a vertical distance) between the reservoir 204 and the immersion tanks 202. To control fluid flow and/or a flow rate of the first working fluid 112 between the reservoir 204 and the servers 212 (e.g., to be less than a maximum flow rate), the immersion cooling system 102 of the illustrated example includes a plurality of flow control devices or control valves 214. In some examples, the control valves 214 (e.g., ball valves, globe valves, shut-off valves, etc.) can shut off fluid flow between the reservoir 204 and the respective ones of the immersion tanks 202 and/or respective ones of the servers 212. In some examples, the control valves 214 can be employed to control a fluid flow rate of the first working fluid 112 between the reservoir 204 and the respective ones of the immersion tanks 202 and/or the respective ones of the servers 212. For example, referring to the first immersion tank 202a, each server 212a-f includes a respective one of the control valves 214a-f. Thus, the first immersion tank 202a of the illustrated example includes six control valves 214 (e.g., a control valve for each one of the servers 212a-f). In this manner, a flow rate of the first working fluid 112 to each one of the servers 212a-f can be controlled individually. In some examples, the first server 212a can be provided with the first working fluid 112 having a greater flow rate compared to a flow rate of the first working fluid 112 provided to the second server 212b. In this manner, the first server 212a can be provided with the first working fluid 112 having a first flow rate and the second server 212b can be provided with the first working fluid 112 having a second flow rate (e.g., a reduced flow rate of the first working fluid) when the first server 212a is performing at a higher power output compared to a power output of the second server 212b. In some examples, a control valve 214g can be interposed in a waterfall conduit 210b. In this manner, the first working fluid 112 can be controlled to the servers 212 in a second immersion tank 202b collectively. For example, the control valve 214g can be employed to control a flow rate and/or fluid flow of the first working fluid 112 to all of the servers 212 located in the second immersion tank 202b. Thus, in this example, each one of the servers 212 in the second immersion tank 202b receives the first working fluid 112 with the same flow rate. The control valves 214 can also be used to shut-off fluid flow (e.g., completely shut-off) to one or more of the servers 212 and/or immersion tanks 202. For example, if a server 212 within an immersion tank 202 and/or the servers 212 within an immersion tank 202 are not operating, flow of the first working fluid 112 to the servers 212 and/or the immersion tanks 202 can be shut-off. In some examples, flow of first working fluid 112 can be shut-off via the control valves 214 to perform maintenance, replacement and/or repair of one or more servers 212 in the immersion tanks 202. In some examples, one or more of the control valves 214 can be omitted.

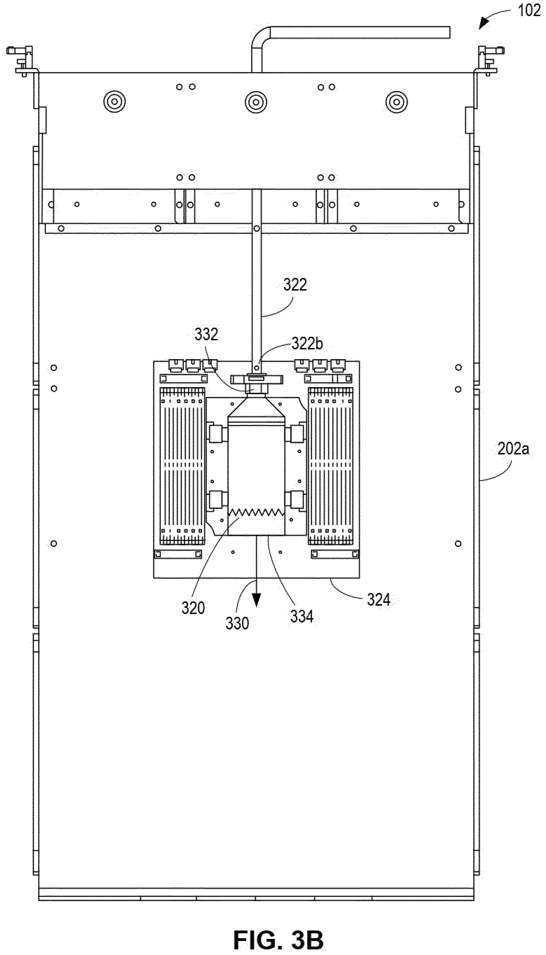

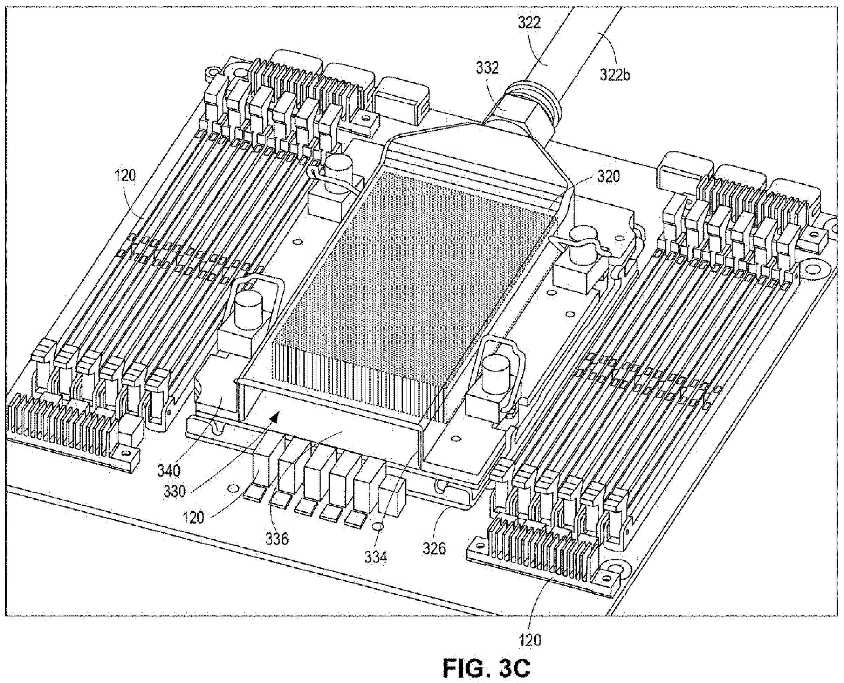

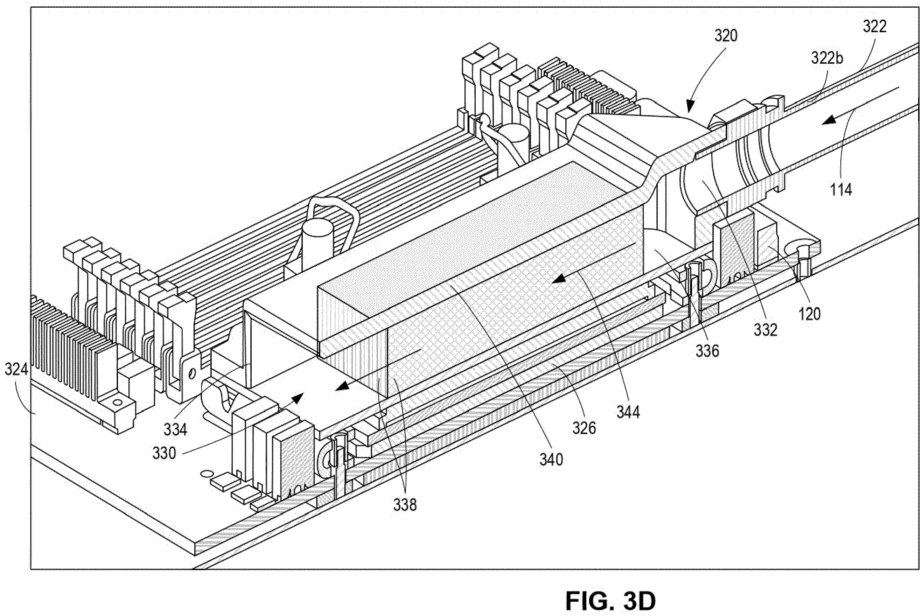

FIG. 3A is a schematic side view of the example first immersion tank 202a of the example immersion cooling system 102 of FIG. 2. FIG. 3B is a side view of the example first server 212a of the first immersion tank 202a of FIG. 3A. FIG. 3C is a perspective view of the first server 212a of FIGS. 3A and 3B. FIG. 3D is a perspective, cross-sectional view of the first server 212a of FIGS. 3A-3C.

Referring to FIG. 3A, the first immersion tank 202a is filled with the first working fluid 112 to a tank liquid surface level 302. The reservoir 204 is filled with the first working fluid 112 to provide a reservoir liquid surface level 304. Additionally, the reservoir 204 is positioned above the first immersion tank 202a. As noted above, the reservoir 204 is positioned at the first elevation and the first immersion tank 202a is positioned at the second elevation less than the first elevation. In this manner, a height or distance 306 is provided between the reservoir liquid surface level 304 and the tank liquid surface level 302. As a result, the distance 306 between the reservoir liquid surface level 304 and the tank liquid surface level 302 generates a liquid surface height variance (ΔH_{gravity}) between the reservoir 204 and the first immersion tank 202a.

The first immersion tank 202a of the illustrated example includes an inner wall 308 and an outer wall 310. An inner surface of the inner wall 308 defines a first cavity 312 to receive the first server 212a. An inner surface of the outer wall 310 and an outer surface of the inner wall 308 define a second cavity 314. The first cavity 312 is fluidly coupled to the second cavity 314 via a plurality passages 316 (e.g., holes, apertures, slots, openings, etc.) formed in the inner wall 308. A tank outlet 318 of the first immersion tank 202a is fluidly coupled to the second cavity 314 adjacent a bottom of the first immersion tank 202a. The second cavity 314 fluidly couples the first cavity 312 and the tank outlet 318 via the passages 316. The first cavity 312 and the second cavity 314 receive the first working fluid 112.

The first control valve 214a of the illustrated example is coupled to the first immersion tank 202a but positioned above the tank liquid surface level 302. In the illustrated example, the first waterfall conduit 210a is fluidly coupled to a heat exchanger 320 of the first server 212a. Specifically, the heat exchanger 320 of the illustrated example is fluidly coupled to the first control valve 214a and/or the first waterfall conduit 210a via a coupling conduit 322. The coupling conduit 322 is at least partially submerged in the first working fluid 112 of the first immersion tank 202a. The coupling conduit 322 and/or the waterfall conduits 210 can be a flexible hose, a pipe, a rigid pipe, a duct, and/or any other fluid carrying structure.

Referring to FIGS. 3B-3D, the first server 212a includes a printed circuit board 324, a semiconductor package 326, the heat exchanger 320, and the electronic components 120 (e.g., memory sticks, RAM, etc.). The heat exchanger 320 of the illustrated example includes a chamber 328 defining a fluid flow passageway 330 to enable fluid flow between a first end or an inlet 332 of the heat exchanger 320 and a second end or an outlet 334 of the heat exchanger 320. Specifically, the heat exchanger 320 includes a cold plate 336, a plurality of fins 338, and a cover 340. Specifically, the cover 340 and the cold plate 336 of the heat exchanger 320 define the chamber 328. The fins 338 extend from the cold plate 336 and are positioned in the chamber 328 between the cover 340 and the cold plate 336. The cold plate 336 is coupled to the semiconductor package 326. The fins 338 are spaced apart to define flow channels between respective ones of the fins 338. The inlet 332 of the heat exchanger 320 is coupled to the coupling conduit 322. Therefore, a first end 322a of the coupling conduit 322 is coupled to the first control valve 214a and a second end 322b of the coupling conduit 322 opposite the first end 322a is coupled to the inlet 332 of the heat exchanger 320 and/or the chamber 328. In some examples, the first server 212a can include a plurality of semiconductor packages 326. In such examples, each of the plurality of the semiconductor packages (e.g., XPUs) of the first server 212a can include a dedicated heat exchanger 320. In such examples, a plurality of coupling conduits 322 can couple respective ones of the heat exchangers 320 of the first server 212a and the first control valve 214a and/or the first waterfall conduit 210a.

Referring to FIGS. 3A-3D, in operation, the ability of the immersion cooling system 102 to remove heat from the first server 212a is proportional to a rate at which the first working fluid 112 flows through the immersion cooling system 102. For example, to provide a maximum flow rate, the first control valve 214a can be positioned to a fully open position. To provide a reduced flow rate of the first working fluid 112 to the first server 212a, the first control valve 214a can be adjusted or positioned to a partially open position (e.g., between a fully open position and a fully closed position). To prevent flow of the first working fluid 112 to the first server 212a, the first control valve 214a can be positioned to a fully closed position (e.g., a shut off position). In some examples, the first control valve 214a can be positioned to the fully closed position when the first server 212a needs to be removed from the first immersion tank 202a and/or if the first server 212a is powered off or is not generating significant amount of heat. In some examples, a flow rate of the first working fluid 112 can be adjusted between a first flow rate (e.g., a maximum flow rate) and a second flow rate (e.g., a flow rate less than the maximum flow rate) in response to a power output performance of the first server 212a. In some examples, a control system can be employed to monitor a temperature of the electronic components 120 and/or the servers 212 (e.g., via one or more temperature sensors) and adjust (e.g., increase or decrease) fluid flow to the servers 212 via the control valves 214 based on a power consumption and/or temperature of the electronic components 120 and/or the servers 212.

To cool or remove heat generated by the first server 212a, the first control valve 214a is moved to an open position to allow the first working fluid 112 to flow from the reservoir 204 towards the first immersion tank 202a. The supply manifold 206 supplies the first working fluid 112 to the first waterfall conduit 210a, which provides the first working fluid 112 to the first control valve 214a. Specifically, the first working fluid 112 flows through the first waterfall conduit 210a via gravity. From the first control valve 214a, the first working fluid 112 flows to the heat exchanger 320 via the coupling conduit 322. Specifically, the first working fluid 112 flows from the inlet 332, through the channels and/or across the fins 338, through the outlet 334, and into the first immersion tank 202a (e.g., the first cavity 312).

During operation, heat generated from the semiconductor package 326 is absorbed and/or transferred by the cold plate 336 to the fins 338. The heat exchanger 320 removes heat from thermal challenging components of the first server 212a including the semiconductor package 326 (e.g., XPU, chipsets, etc.). As the first working fluid 112 flows through the chamber 328 of the heat exchanger 320 between the inlet 332 and the outlet 334, the first working fluid 112 flows between and/or across the fins 338 and removes heat from the fins 338 (i.e., removes heat generated by the semiconductor package 326). Specifically, the first working fluid 112 flows through the heat exchanger 320 rapidly or with increased flowrate due to the gravity effect provided by the liquid level surface variance (ΔH_{gravity}) between the reservoir 204 and the first immersion tank 202a. The flowrate of the first working fluid 112 through the heat exchanger 220 affects an amount of heat removed from the first server 212a and, thus, a cooling efficiency of the immersion cooling system 102. Specifically, a greater a flow rate, a greater an amount of heat that can be removed. The slower a flow rate, a lesser amount of heat that can be removed.

After flowing through the heat exchanger 320, the first working fluid 112 exits the heat exchanger 320 via the outlet 334 and flows into the first immersion tank 202a. In the first immersion tank 202a, the first working fluid 112 that exits the heat exchanger 320 flows into the first cavity 312 and continuous to absorb heat generated by the other electronic components 120 (e.g., memory, etc.) of the first server 212a that are coupled to the circuit board 324 and submerged in the first working fluid 112 of the first immersion tank 202a. As the first working fluid 112 in the first cavity 312 of the first immersion tank 202a absorbs heat, a density of the first working fluid 112 in the first cavity 312 decreases, causing the first working fluid 112 in the first cavity 312 to rise to an upper portion or end of the first immersion tank 202a due to convention. As the first working fluid 112 in the first cavity 312 rises, the first working fluid 112 flows out of the first immersion tank 202a and to the return manifold 208. Specifically, as the first working fluid 112 in the first cavity 312 rises, the first working fluid 112 flows to the second cavity 314 via the passages 316 formed in the inner wall 308 of the first immersion tank 202a. The first pump 116 draws the first working fluid 112 from the tank outlet 318 via the return manifold 208 and pumps or recirculates the first working fluid 112 to the reservoir 204. A height 350 (ΔHₚᵤₘₚ) between the tank outlet 318 and the reservoir liquid surface level 304 is the height that the first working fluid 112 should be pumped for pump energy evaluation. The first pump 116 can be a high volume pump needed to move the first working fluid 112 from the tank outlet 318 to the reservoir 204. Thus, the first pump 116 may require minor power consumption. Prior to pumping the first working fluid 112 to the reservoir 204, the first pump 116 recirculates the first working fluid 112 from the first immersion tank 202a to the chiller 104 of FIG. 1 to cool the first working fluid 112 prior to the first working fluid 112 flowing to the reservoir 204.

The first immersion tank 202a automatically balances the tank liquid surface level 302 of the first working fluid 112 in the first immersion tank 202a. Thus, there is no need for complex electrical liquid surface level control sensors or equipment. For example, if a flowrate of the first working fluid 112 increases through the heat exchanger 320, a liquid level surface of the first working fluid 112 in the first cavity 312 also rises, causing a greater amount of the first working fluid 112 in the first cavity 312 to flow through the passages 316 of the inner wall 308 to the second cavity 314. Conversely, if the flow rate of the first working fluid 112 decreases through the heat exchanger 320, a liquid level of the first working fluid 112 in the first immersion tank 202a decreases and a lesser amount of the first working fluid 112 in the first cavity 312 flows through the passages 316 to the second cavity 314. Thus, the first working fluid 112 in the first immersion tank 202a self-levels based on a flowrate of the first working fluid 112.

Thus, the gravity effect and/or pressure head of the example immersion cooling system 102 significantly improves a cooling capability of the immersion cooling system 102. In some examples, a liquid height variance (ΔH_{gravity}) of approximately 1.4 meters between the reservoir 204 and the immersion tanks 202 can increase a flowrate of the immersion cooling system 102 from about 3.1 liters per minute (LPM) to approximately 3.9 liters per minute (LPM). In comparison, a cooling system implemented without the example reservoir 204 that includes a pump to cause fluid flow through an immersion tank having a height of 1 meter, typically provides a cooling capability of an immersion cooling system of approximately 900 watts (W). With the implementation of the example immersion cooling system 102 disclosed herein, an immersion cooling system 102 including a reservoir 204 at a height of approximately 2 meters (e.g., ΔH_{gravity} = 2 meters) provides an increased flowrate of approximately 7 liters per minute and a cooling capability of approximately 1050 watts (W) due to the increased pressure head provided by the reservoir. In some examples, a cooling system including the reservoir 204 disclosed herein at a height of approximately 3 meters (e.g., ΔH_{gravity} = 3 meters) provides an increased flowrate of approximately 9 liters per minute and a cooling capability of approximately 1106 watts (W) due to the increased pressure head provided by the reservoir 204.

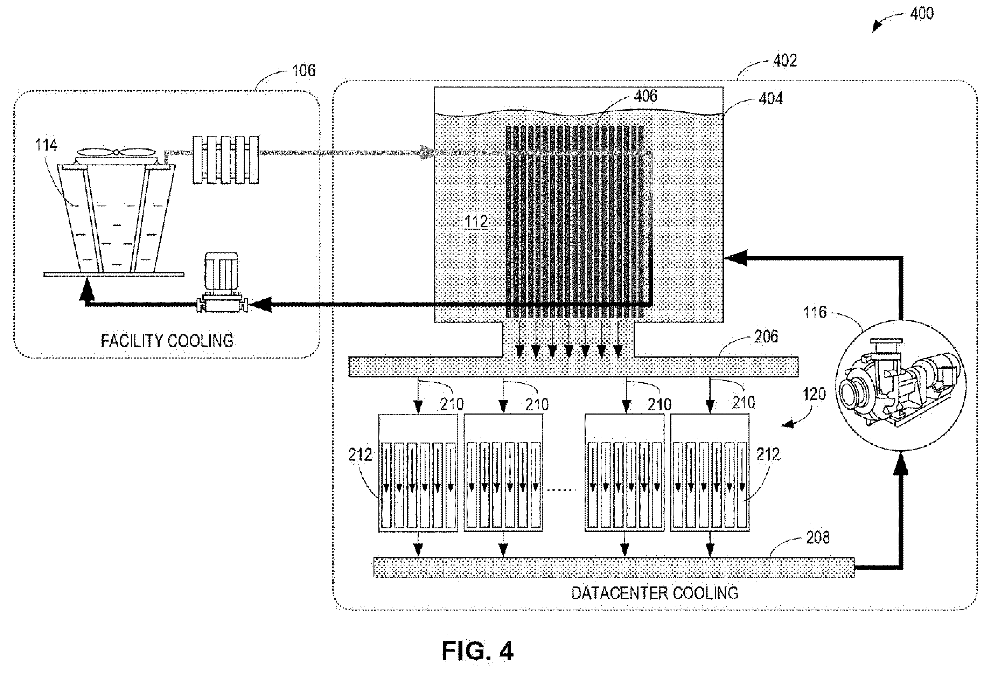

FIG. 4 is a schematic illustration of an example computing environment 400 having an example immersion cooling system 402 disclosed herein. Many of the components of the example immersion cooling system 402 of FIG. 4 are substantially similar or identical to the components described above in connection with FIGS. 1, 2, and 3A-3D. As such, those components will not be described in detail again below. Instead, the interested reader is referred to the above corresponding descriptions for a complete written description of the structure and operation of such components. To facilitate this process, similar or identical reference numbers will be used for like structures in FIG. 4 as used in FIGS. 1, 2, and 3A-3D. For example, the immersion cooling system 402 of FIG. 4 includes a supply manifold 206, a plurality of waterfall conduits 210, a plurality of immersion tanks 202 housing a plurality of electronic components 120 and/or servers 212, and a cooling tower 106. The immersion cooling system 402 of the illustrated example includes a reservoir 404 having a heat exchanger 406 to cool a first working fluid 112 in the reservoir 404 when the first working fluid 112 is in the reservoir 404. Thus, the immersion cooling system 402 of FIG. 4 is substantially similar to the immersion cooling system 102 of FIGS. 1, 2 and 3A-3D except that the reservoir 404 includes the heat exchanger 406. In the illustrated example, the heat exchanger 406 is fluidly coupled to a second loop system 110. Thus, the heat exchanger 406 of the illustrated example receives a second working fluid 114 from the cooling tower 106. The second working fluid 114 absorbs and/or removes heat from the first working fluid 112 in the reservoir 404 when the second working fluid 114 circulates through the heat exchanger 406 via the second loop system 110. By positioning the heat exchanger 406 in the reservoir 404, the example immersion cooling system 402 of the illustrated example can preserve space and/or improve heat exchange efficiency of the immersion cooling system 402.

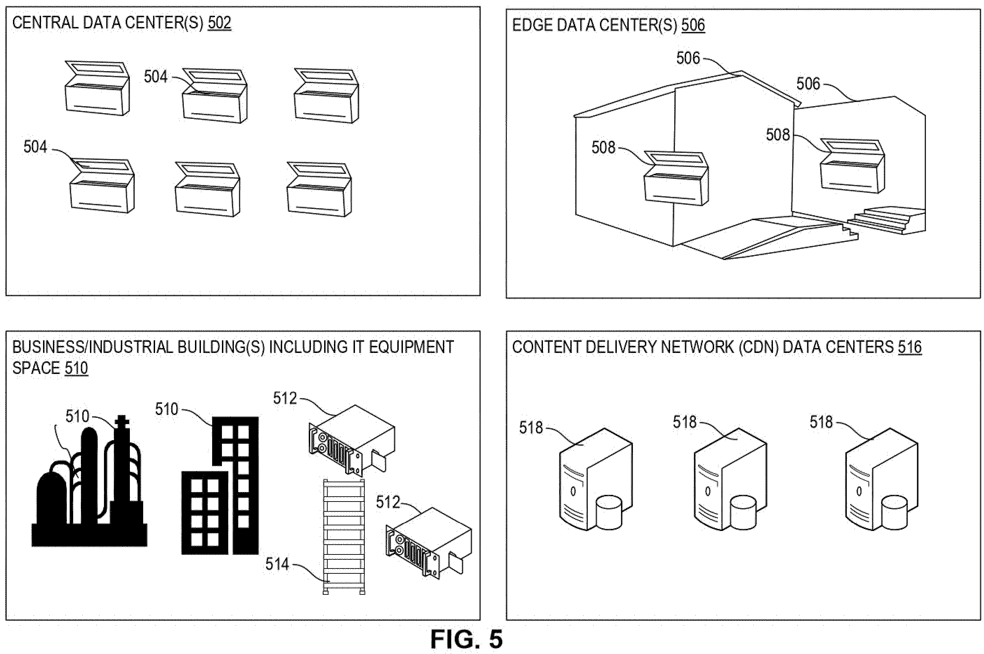

FIG. 5 illustrates one or more example environments in which teachings of this disclosure may be implemented. The example environment(s) of FIG. 5 can include one or more central data centers 502. The central data center(s) 502 can store a large number of servers used by, for instance, one or more organizations for data processing, storage, etc. As illustrated in FIG. 5, the central data center(s) 502 include a plurality of immersion tank(s) 504 to facilitate cooling of the servers and/or other electronic components stored at the central data center(s) 502. The immersion tank(s) 504 can provide for single-phase cooling or two-phase cooling.

The example environments of FIG. 5 can be part of an edge computing system. For instance, the example environments of FIG. 5 can include edge data centers or micro-data centers 506. The edge data center(s) 506 can include, for example, data centers located at a base of a cell tower. In some examples, the edge data center(s) 506 are located at or near a top of a cell tower and/or other utility pole. The edge data center(s) 506 include respective housings that store server(s), where the server(s) can be in communication with, for instance, the server(s) stored at the central data center(s) 502, client devices, and/or other computing devices in the edge network. Example housings of the edge data center(s) 506 may include materials that form one or more exterior surfaces that partially or fully protect contents therein, in which protection may include weather protection, hazardous environment protection (e.g., electromagnetic interference (EMI), vibration, extreme temperatures), and/or enable submergibility. Example housings may include power circuitry to provide power for stationary and/or portable implementations, such as alternating current (AC) power inputs, direct current (DC) power inputs, AC/DC or DC/AC converter(s), power regulators, transformers, charging circuitry, batteries, wired inputs and/or wireless power inputs. As illustrated in FIG. 5, the edge data center(s) 506 can include immersion tank(s) 508 to store server(s) and/or other electronic component(s) located at the edge data center(s) 506.

The example environment(s) of FIG. 5 can include buildings 510 for purposes of business and/or industry that store information technology (IT) equipment in, for example, one or more rooms of the building(s) 510. For example, as represented in FIG. 5, server(s) 512 can be stored with server rack(s) 514 that support the server(s) 512 (e.g., in an opening of slot of the rack 514). In some examples, the server(s) 512 located at the buildings 510 include on-premise server(s) of an edge computing network, where the on-premise server(s) are in communication with remote server(s) (e.g., the server(s) at the edge data center(s) 506) and/or other computing device(s) within an edge network.

The example environment(s) of FIG. 5 include content delivery network (CDN) data center(s) 516. The CDN data center(s) 516 of this example include server(s) 518 that cache content such as images, webpages, videos, etc. accessed via user devices. The server(s) 518 of the CDN data centers 516 can be disposed in immersion cooling tank(s) such as the immersion tanks 504, 508 shown in connection with the data centers 502, 506. In some instances, the example data centers 502, 506, 516 and/or building(s) 510 of FIG. 5 include servers and/or other electronic components that are cooled independent of immersion tanks (e.g., the immersion tanks 504, 508) and/or an associated immersion cooling system.

Although a certain number of cooling tank(s) and other component(s) are shown in the figures, any number of such components may be present. Also, the example cooling data centers and/or other structures or environments disclosed herein are not limited to arrangements of the size that are depicted in FIG. 5. For instance, the structures containing example cooling systems and/or components thereof disclosed herein can be of a size that includes an opening to accommodate service personnel, such as the example data center(s) 506 of FIG. 5, but can also be smaller (e.g., a "doghouse" enclosure). For instance, the structures containing example cooling systems and/or components thereof disclosed herein can be sized such that access (e.g., the only access) to an interior of the structure is a port for service personnel to reach into the structure. In some examples, the structures containing example cooling systems and/or components thereof disclosed herein can be sized such that only a tool can reach into the enclosure because the structure may be supported by, for a utility pole or radio tower, or a larger structure. In addition to or as an alternative to the immersion tanks 504, 508, any of the example environments of FIG. 5 can utilize one or more liquid cooling systems having a cold plate to control the temperature of the electronic devices/components in the example environments.

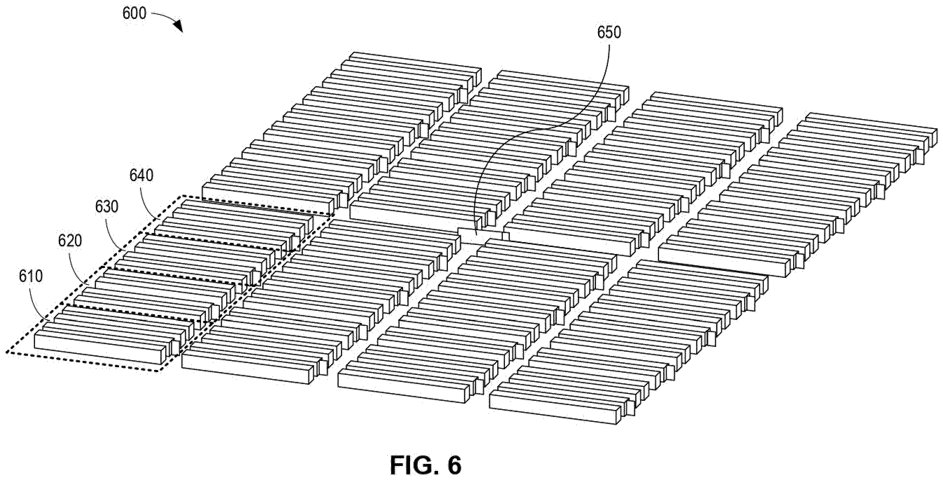

FIG. 6 illustrates an example data center 600 in which disaggregated resources may cooperatively execute one or more workloads (e.g., applications on behalf of customers). The illustrated data center 600 includes multiple platforms 610, 620, 630, 640 (referred to herein as pods), each of which includes one or more rows of racks. Although the data center 600 is shown with multiple pods, in some examples, the data center 600 may be implemented as a single pod. As described in more detail herein, a rack may house multiple sleds. A sled may be primarily equipped with a particular type of resource (e.g., memory devices, data storage devices, accelerator devices, general purpose programmable circuitry) that can be logically coupled to form a composed node. Some such nodes may function as, for example, a server. In some examples, one or more sleds can be configured to be mounted in a corresponding rack 740 of the data center 600 discussed above. In some examples, a given sled may be optimized or otherwise configured for performing particular tasks, such as compute tasks, acceleration tasks, data storage tasks, etc. For example, a sled may be implemented as a compute sled , an accelerator sled , a storage sled, a sled optimized or otherwise configured to perform other specialized tasks, such as a memory sled and/or any other configuration.

In the illustrative example, the sleds in the pods 610, 620, 630, 640 are connected to multiple pod switches (e.g., switches that route data communications to and from sleds within the pod). The pod switches, in turn, connect with spine switches 650 that switch communications among pods (e.g., the pods 610, 620, 630, 640) in the data center 600. In some examples, the sleds may be connected with a fabric using Intel Omni-Path^{™} technology. In other examples, the sleds may be connected with other fabrics, such as InfiniBand or Ethernet. As described in more detail herein, resources within the sleds in the data center 600 may be allocated to a group (referred to herein as a "managed node") containing resources from one or more sleds to be collectively utilized in the execution of a workload. The workload can execute as if the resources belonging to the managed node were located on the same sled. The resources in a managed node may belong to sleds belonging to different racks, and even to different pods 610, 620, 630, 640. As such, some resources of a single sled may be allocated to one managed node while other resources of the same sled are allocated to a different managed node (e.g., first programmable circuitry assigned to one managed node and second programmable circuitry of the same sled assigned to a different managed node).

A data center including disaggregated resources, such as the data center 600, can be used in a wide variety of contexts, such as enterprise, government, cloud service provider, and communications service provider (e.g., a telecommunications provider, a telephone company (e.g., a Telco), as well in a wide variety of sizes, from cloud service provider mega-data centers that consume over 200,000 sq. ft. to single- or multi-rack installations for use in base stations.

In some examples, the disaggregation of resources is accomplished by using individual sleds that include predominantly a single type of resource (e.g., compute sleds including primarily compute resources, memory sleds including primarily memory resources). The disaggregation of resources in this manner, and the selective allocation and deallocation of the disaggregated resources to form a managed node assigned to execute a workload, improves the operation and resource usage of the data center 600 relative to typical data centers. Such typical data centers include hyperconverged servers containing compute, memory, storage and perhaps additional resources in a single chassis. For example, because a given sled will contain mostly resources of a same particular type, resources of that type can be upgraded independently of other resources. Additionally, because different resource types (programmable circuitry, storage, accelerators, etc.) typically have different refresh rates, greater resource utilization and reduced total cost of ownership may be achieved. For example, a data center operator can upgrade the programmable circuitry throughout a facility by only swapping out the compute sleds. In such a case, accelerator and storage resources may not be contemporaneously upgraded and, rather, may be allowed to continue operating until those resources are scheduled for their own refresh. Resource utilization may also increase. For example, if managed nodes are composed based on requirements of the workloads that will be running on them, resources within a node are more likely to be fully utilized. Such utilization may allow for more managed nodes to run in a data center with a given set of resources, or for a data center expected to run a given set of workloads, to be built using fewer resources.

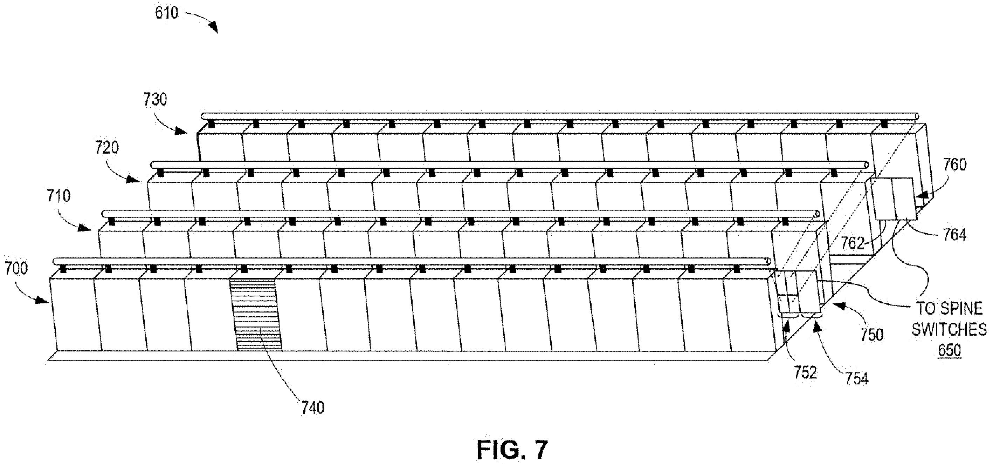

Referring now to FIG. 7, the pod 610, in the illustrative example, includes a set of rows 700, 710, 720, 730 of racks 740. Individual ones of the racks 740 may house multiple sleds (e.g., sixteen sleds) and provide power and data connections to the housed sleds, as described in more detail herein. In the illustrative example, the racks are connected to multiple pod switches 750, 760. The pod switch 750 includes a set of ports 752 to which the sleds of the racks of the pod 610 are connected and another set of ports 754 that connect the pod 610 to the spine switches 650 to provide connectivity to other pods in the data center 600. Similarly, the pod switch 760 includes a set of ports 762 to which the sleds of the racks of the pod 610 are connected and a set of ports 764 that connect the pod 610 to the spine switches 650. As such, the use of the pair of switches 750, 760 provides an amount of redundancy to the pod 610. For example, if either of the switches 750, 760 fails, the sleds in the pod 610 may still maintain data communication with the remainder of the data center 600 (e.g., sleds of other pods) through the other switch 750, 760. Furthermore, in the illustrative example, the switches 650, 750, 760 may be implemented as dual-mode optical switches, capable of routing both Ethernet protocol communications carrying Internet Protocol (IP) packets and communications according to a second, high-performance link-layer protocol (e.g., Peripheral Component Interconnect (PCI) Express (PCIe)) via optical signaling media of an optical fabric.

It should be appreciated that any one of the other pods 620, 630, 640 (as well as any additional pods of the data center 600) may be similarly structured as, and have components similar to, the pod 610 shown in and disclosed in regard to FIG. 7 (e.g., a given pod may have rows of racks housing multiple sleds as described above). Additionally, while two pod switches 750, 760 are shown, it should be understood that in other examples, a different number of pod switches may be present, providing even more failover capacity. In other examples, pods may be arranged differently than the rows-of-racks configuration shown in FIGS. 6 and 7. For example, a pod may include multiple sets of racks arranged radially (e.g., the racks are equidistant from a center switch). The server pods of the illustrated example can include one or more immersion cooling tanks. By immersing servers in a dielectric fluid within the tank, heat is directly absorbed and dissipated, which can significantly reduce the need for traditional air conditioning and improve overall energy efficiency.

Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that improve cooling capability of immersion cooling systems. Further examples and combinations thereof include the following:
Example 1 includes an immersion cooling system comprising an immersion tank including a cooling fluid, a reservoir to contain a recirculated portion of the cooling fluid, the reservoir separated from the immersion tank by a height to generate a liquid surface height variance between the cooling fluid in the immersion tank and the cooling fluid in the reservoir, and a supply conduit to fluidly couple the immersion tank and the reservoir, the cooling fluid to be provided from the reservoir to the immersion tank via gravity.
Example 2 includes the system of example 1, further including a waterfall conduit between the supply conduit and the immersion tank.
Example 3 includes the system of any one of examples 1-2, further including a control valve coupled to the waterfall conduit.
Example 4 includes the system of any one of examples 1-3, further including a coupling conduit to the control valve and a heat exchanger of an electronic component positioned in the immersion tank.
Example 5 includes the system of any one of examples 1-4, wherein the control valve is to control a fluid flow rate of the cooling fluid flowing from the reservoir to the heat exchanger.
Example 6 includes the system of any one of examples 1-5, further including a return manifold coupled to an outlet of the immersion tank.
Example 7 includes the system of any one of examples 1-6, further including a first pump to recirculate the cooling fluid at the outlet of the immersion tank to the reservoir.
Example 8 includes the system of any one of examples 1-7, further including a chiller interposed between the return manifold and the reservoir, the chiller to remove heat from the cooling fluid.
Example 9 includes the system of any one of examples 1-8, further including a cooling tower to provide a working fluid to the chiller, the working fluid to remove the heat from the cooling fluid as the cooling fluid flows through the chiller as the cooling fluid recirculates from the outlet of the immersion tank and the reservoir.
Example 10 includes the system of any one of examples 1-9, wherein the immersion tank includes an inner wall and an outer wall, the inner wall defining a first cavity, the inner wall and the outer wall defining a second cavity.
Example 11 includes the system of any one of examples 1-10, wherein the second cavity is fluidly coupled to an outlet of the immersion tank.
Example 12 includes the system of any one of examples 1-11, wherein the first cavity is fluidly coupled to the second cavity via one or more passages formed through the inner wall.
Example 13 includes the system of any one of examples 1-12, wherein the immersion tank is positioned at a first elevation and the reservoir is positioned at a second elevation, the second elevation greater than the first elevation.
Example 14 includes the system of any one of examples 1-13, wherein the cooling fluid in the first cavity flows to the second cavity when a density of the cooling fluid in the first cavity decreases.
Example 15 includes an immersion cooling system comprising an electronic assembly including a frame, a printed circuit board mounted to the frame, a semiconductor chip package coupled to the printed circuit board, a heat sink having a fluid flow cavity that includes fins, the heat sink coupled to the semiconductor chip package, a first chamber including a first volume of a liquid coolant, the first chamber at a first elevation, the electronic assembly submerged within the liquid coolant of the liquid chamber, a second chamber including a second volume of the liquid coolant, the second chamber at a second elevation different than the first elevation such that a pressure head is provided between the second volume of the liquid coolant of the second chamber and the first volume of the liquid coolant of the first chamber.
Example 16 includes the system of any one of examples 1-15, further including a pipe fluidly coupling the liquid coolant of the second chamber and the cavity of the heat sink of the electronic assembly submerged in the first chamber.
Example 17 includes the system of any one of examples 1-16, wherein the pressure head provided between the first chamber and the second chamber is to provide a fluid flowrate of the liquid coolant flowing from the second chamber to the first chamber.
Example 18 includes the system of any one of examples 1-15, wherein an outlet of the fluid flow cavity of heat sink is in fluid communication with the liquid coolant in the first chamber such that the liquid coolant flowing from the second chamber through the cavity of the heat exchanger deposits into the first chamber.
Example 19 includes a system including a first chamber including an immersion bath liquid, an electronic unit within the immersion bath liquid, a heat exchanger coupled to the electronic unit, a second chamber spaced from the first chamber to create a pressure head, the second chamber including the immersion bath liquid, and a flow channel fluidly coupling the second chamber and the heat exchanger, the flow channel to enable fluid flow through the exchanger that is coupled to a semiconductor chip package of the electronic unit.
Example 20 includes the system of example 19, further including a control valve interposed in the second flow channel to control fluid flow to the heat exchanger.
The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An immersion cooling system comprising:
an immersion tank including a cooling fluid;
a reservoir to contain a recirculated portion of the cooling fluid, the reservoir separated from the immersion tank by a height to generate a liquid surface height variance between the cooling fluid in the immersion tank and the cooling fluid in the reservoir; and
a supply conduit to fluidly couple the immersion tank and the reservoir, the cooling fluid to be provided from the reservoir to the immersion tank via gravity.

2. The system of claim 1, further including a waterfall conduit between the supply conduit and the immersion tank.

3. The system of any one of claims 1-2, further including a control valve coupled to the waterfall conduit.

4. The system of any one of claims 1- 3, further including a coupling conduit to the control valve and a heat exchanger of an electronic component positioned in the immersion tank.

5. The system of any one of claims 1- 4, wherein the control valve is to control a fluid flow rate of the cooling fluid flowing from the reservoir to the heat exchanger.

6. The system of any one of claims 1-5, further including a return manifold coupled to an outlet of the immersion tank.

7. The system of any one of claims 1-6, further including a first pump to recirculate the cooling fluid at the outlet of the immersion tank to the reservoir.

8. The system of any one of claims 1- 7, further including a chiller interposed between the return manifold and the reservoir, the chiller to remove heat from the cooling fluid.

9. The system of any one of claims 1-8, further including a cooling tower to provide a working fluid to the chiller, the working fluid to remove the heat from the cooling fluid as the cooling fluid flows through the chiller as the cooling fluid recirculates from the outlet of the immersion tank and the reservoir.

10. The system of any one of claims 1-9, wherein the immersion tank includes an inner wall and an outer wall, the inner wall defining a first cavity, the inner wall and the outer wall defining a second cavity.

11. The system of any one of claims 1-10, wherein the second cavity is fluidly coupled to an outlet of the immersion tank.

12. The system of any one of claims 1-11, wherein the first cavity is fluidly coupled to the second cavity via one or more passages formed through the inner wall.

13. The system of any one of claims 1-12, wherein the immersion tank is positioned at a first elevation and the reservoir is positioned at a second elevation, the second elevation greater than the first elevation.

14. The system of any one of claims 1-13, wherein the cooling fluid in the first cavity flows to the second cavity when a density of the cooling fluid in the first cavity decreases.

15. The system of any one of claims 1-14, further including:
an electronic assembly having:
a frame;
a printed circuit board mounted to the frame;
a semiconductor chip package coupled to the printed circuit board; and
a heat sink having a fluid flow cavity that includes fins, the heat sink coupled to the semiconductor chip package, wherein
the electronic assembly is submerged within the cooling liquid of the immersion tank.
